Europäisches Patentamt

European Patent Office

Office européen des brevets

(11) Publication number: **0 055 038**
**B1**

## (12) EUROPEAN PATENT SPECIFICATION

(45) Date of publication of patent specification: **06.08.86**

(21) Application number: **81305676.9**

(22) Date of filing: **02.12.81**

(51) Int. Cl.⁴: **H 01 L 23/56,** H 01 L 23/52,
G 11 C 11/24, G 11 C 11/34

(54) **Control of a signal voltage for a semiconductor device.**

(30) Priority: **03.12.80 JP 170748/80**

(43) Date of publication of application:
**30.06.82 Bulletin 82/26**

(45) Publication of the grant of the patent:
**06.08.86 Bulletin 86/32**

(84) Designated Contracting States:
**DE FR GB NL**

(56) References cited:
**US-A-3 646 369**
**US-A-4 250 414**

**IEEE JOURNAL OF SOLID-STATE CIRCUITS,**
vol. SC-16, no. 5, October 1981, New York M.
TANIGUCHI et al. "Fully boosted 64K Dynamic
RAM with automatic and self-refresh"

(73) Proprietor: **FUJITSU LIMITED**
**1015, Kamikodanaka Nakahara-ku**
**Kawasaki-shi Kanagawa 211 (JP)**

(72) Inventor: **Nozaki, Shigeki**
**473-4-203, Hisasue Takatsu-ku**
**Kawasaki-shi Kanagawa 213 (JP)**
Inventor: **Kabashima, Katsuhiko**
**407-1, Miyauchi Nakahara-ku**
**Kawasaki-shi Kanagawa 211 (JP)**
Inventor: **Takemae, Yoshihiro**
**1-20-5-9-301, Utsukushigaoka Midori-ku**
**Yokohama-shi Kanagawa 227 (JP)**
Inventor:. **Enomoto, Seiji**
**3-16-403, Susukinodanchi Midori-ku**
**Yokohama-shi Kanagawa 227 (JP)**

(74) Representative: **George, Sidney Arthur et al**
**GILL JENNINGS & EVERY 53-64 Chancery Lane**
**London WC2A 1HN (GB)**

## Description

This invention relates to a semiconductor device, and especially to a semiconductor device comprising a signal line in which a voltage higher than the supply voltage is generated.

Recently, in known devices, the voltage supply $V_{cc}$ of a dynamic RAM (Random Access Memory) using MOS transistors has been lowered by degrees and, in general, $V_{cc}=5V$. However, the electric charge accumulated in the memory cell in the case of $V_{cc}=5V$ is less than that in the case where $V_{cc}=12V$ or another higher voltage. Accordingly, the charging condition in the memory cell in the case where $V_{cc}=5V$ is disadvantageous for carrying out a refresh action and is apt to be influenced by α-rays and so on. It therefore becomes necessary to generate a voltage higher than the voltage supply $V_{cc}$ at the signal line by using a bootstrap circuit, a push-up circuit or other type of circuit in order to utilise the $V_{cc}$ level as much as possible.

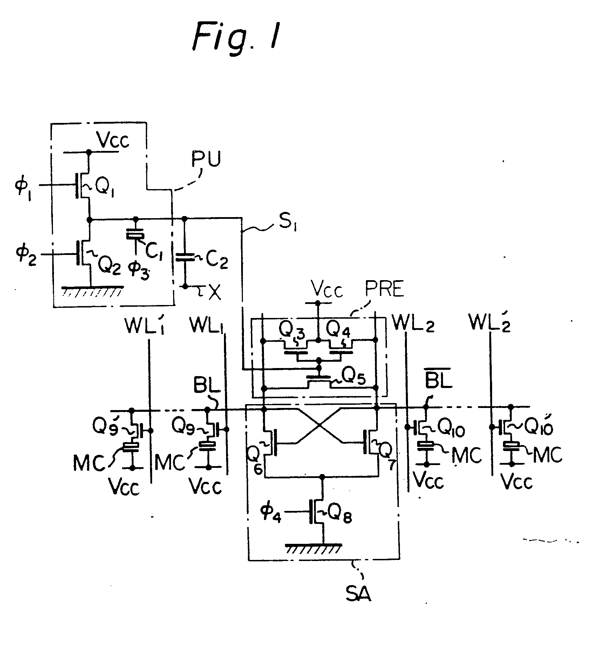

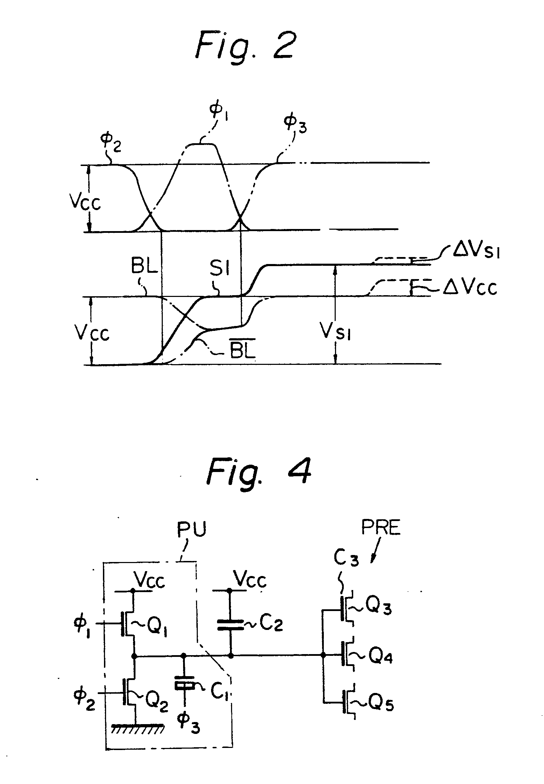

A prior dynamic RAM semiconductor device in which a push-up circuit is used for the above-mentioned purpose is illustrated in Figure 1 of the accompanying drawings. Details of this device have not previously been published. The device has a push-up circuit PU, a precharger circuit PRE for a pair of bit lines BL and $\overline{BL}$ which are driven by the output of the push-up circuit PU, and a sense amplifier circuit SA for the memory cells. Figure 2 illustrates various voltage waveforms used to explain the operation of the push-up circuit PU of Figure 1.

The push-up circuit PU consists of transitors $Q_1$ and $Q_2$, a push-up capacitance $C_1$ and an output signal line $S_1$, as illustrated in Figure 1. A clock signal $\phi_1$ is fed to the gate of the transistor $Q_1$ and another clock signal $\phi_2$ is fed to the gate of the transistor $Q_2$. As illustrated in Figure 2, the clock $\phi_1$ is at first at an L (low) level and the clock $\phi_2$ is at the H (high) level corresponding to the voltage of the power supply $V_{cc}$, so that the transistor $Q_1$ is OFF and the transistor $Q_2$ is ON; therefore, the level of the output signal line $S_1$ is kept at the L level ($V_{ss}$). Then, the clock $\phi_2$ falls to the L level to turn off the transistor $Q_2$; after that the clock $\phi_1$ rises to the H level (higher than $V_{cc}$) to fully turn on the transistor $Q_1$ so that the signal line $S_1$ is charged up to the $V_{cc}$ level. Under this condition, the clock $\phi_1$ falls to the L level to turn off the transistor $Q_1$, and therefore the signal line $S_1$ is cut off from the voltage supply line $V_{cc}$. Then, the clock $\phi_3$ rises from the L level ($V_{ss}$) to the H level ($V_{cc}$) so that the level of the signal line $S_1$ is pushed up to a level $V_{s1}$ higher than the voltage supply $V_{cc}$ through the capacity $C_1$.

This voltage level $V_{s1}$ of the signal line $S_1$ is inputted into the precharger circuit PRE. As illustrated in Figure 1, the precharger circuit PRE consists of transistors $Q_3$, $Q_4$ and $Q_5$. The signal line $S_1$ is connected to all the gates of the transistors $Q_3$, $Q_4$ and $Q_5$. The drains of transistors $Q_3$ and $Q_4$ are connected to the voltage supply $V_{cc}$, and the sources of the transistors $Q_3$ and $Q_4$ are connected to the pair of bit lines BL and $\overline{BL}$ respectively. The drain and source of the transistor $Q_5$ are connected to the pair of bit lines BL and $\overline{BL}$ respectively.

The sense amplifier circuit SA consists of transistors $Q_6$, $Q_7$ $Q_8$ as illustrated in Figure 1. The drain of the transistor $Q_6$ and the gate of the transistor $Q_7$ are both connected to one line BL of the pair of bit lines, and the gate of the transistor $Q_6$ and the drain of the transistor $Q_7$ are both connected to another line $\overline{BL}$ of the pair of bit lines. The sources of the transistors $Q_6$ and $Q_7$ are both connected to the drain of the transistor $Q_8$, and the source of the transistor $Q_8$ is connected to the reference voltage $V_{ss}$. The clock signal $\phi_4$ is applied to the gate of the transistor $Q_8$.

Transistors $Q_9$, $Q_9'$... of the memory cells MC corresponding to the word lines $WL_1$, $WL_1'$ ... are all connected to one line BL of the pair of bit lines, and transistors $Q_{10}$, $Q_{10}'$ ... of the memory cells MC corresponding to the word lines $WL_2$, $WL_2'$ ... are all connected to another line $\overline{BL}$ of the pair of bit lines. For example, if the content of the memory cell MC including the transistor $Q_9$ is "1" and the word line $WL_1$ is selected, when the clock $\phi_4$ rises from the L level to the H level to turn on the transistor $Q_8$, the sense amplifier circuit SA operates to turn off the transistor $Q_6$ and to turn on the transistor $Q_7$ so that the levels of the pair of bit lines are BL=H and $\overline{BL}$=L. And if the content of the above-mentioned memory cell MC is "0", then the circuit SA operates to turn on the transistor $Q_6$ and to turn off the transistor $Q_7$ so that the levels of the pair of bit lines are BL=L and $\overline{BL}$=H.

In the sense amplifier circuit SA, preceding the above-mentioned sense action, it is necessary to precharge the pair of bit lines BL and $\overline{BL}$ so as to make the potentials of the pair of bit lines BL and $\overline{BL}$ equal to each other. In order to do so, when the clock $\phi_1$ rises to the H level as illustrated in Fig. 2, the gate voltages of the transistors $Q_3$, $Q_4$ and $Q_5$ rise to the $V_{cc}$ level through the signal line $S_1$ and the pair of bit lines BL and $\overline{BL}$ are charged up from the voltage supply $V_{cc}$ through the transistors $Q_3$ and $Q_4$, respectively. The transistor $Q_5$ is connected between the pair of bit lines BL and $\overline{BL}$, and it becomes conductive in order to make the potentials of the pair of bit lines BL and $\overline{BL}$ equal to each other. However, in the above-mentioned condition, the level of the signal line $S_1$ is nearly equal to the voltage supply $V_{cc}$ so that the transistors $Q_3$, $Q_4$ and $Q_5$ are not turned on fully, and therefore the potentials of the pair of bit lines BL and $\overline{BL}$ are lower than $V_{cc}$ and are not completely equal to each other. Then, when the clock $\phi_1$ falls to the L level and the clock $\phi_3$ rises to the H level, the level of the signal line $S_1$ rises from $V_{cc}$ to $V_{s1}$ higher than $V_{cc}$ so that the transistors $Q_3$, $Q_4$ and $Q_5$ are fully turned on and the pair of bit lines BL and $\overline{BL}$ are both charged up to the voltage supply level $V_{cc}$.

The level $V_{s1}$ of the signal line $S_1$ is determined not only by the voltage supply $V_{cc}$ and the level $V_{\phi3}$ of the clock $\phi_3$ (in this case, $V_{\phi3}=V_{cc}$) but is also determined by the push-up capacity $C_1$, a parasitic capacity $C_2$ formed along the wiring path of the signal line $S_1$, and the capacity $C_3$ at the gates of the transistors $Q_3$, $Q_4$ and $Q_5$. Thus, the level $V_{S1}$ of the signal line $S_1$ is expressed by the following equation, when the potential of the opposite electrode X of the capacity $C_2$ is $V_{SS}$:

$$V_{S1}=V_{CC}+V_{\phi3}\cdot\frac{C_1}{C_1+C_2+C_3} \qquad (1)$$

In order to charge up the pair of bit lines BL and $\overline{BL}$ to the voltage supply level $V_{CC}$, it is necessary that the second term of the right side of the equation (1) be greater than the threshold voltage $V_{th}$ of the transistors $Q_3$, $Q_4$ and $Q_5$.

However, even if the condition $V_{S1}\geqq V_{CC}+V_{th}$ is fulfilled in the case of $V_{CC}=5V$ and the pair of bit lines BL and $\overline{BL}$ are both charged up to the voltage supply level $V_{CC}$, the voltage supply $V_{CC}$ may rise from 5V to 5.5 V ($V_{CC}+\Delta V_{CC}$) after that. In such a case, the value of "$V_{CC}$" in the equation (1) will remain 5 V because at this time the clock $\phi_1$ has already fallen enough so that the transistor $Q_1$ is turned off. Accordingly, the response of the level of the signal line $S_1$ to the variance of the voltage supply $V_{CC}$ depends mainly on the dependence of the clock $\phi_3$ upon the voltage supply $V_{CC}$. An increase in the level of the signal line $S_1$ is expressed by the following equation:

$$\Delta V_{S1}=\Delta V_{\phi3}\cdot\frac{C_1}{C_1+C_2+C_3} \qquad (2)$$

Therefore, even if the clock $\phi_3$ follows directly to the variance of the voltage supply $V_{CC}$, the level of the signal line $S_1$ may increase only a little compared with the increase of $V_{CC}$ especially in the case that the capacity $C_2$ is relatively large (that is, the path of the signal line $S_1$ is long). Therefore, if the voltage supply $V_{CC}$ is changed, it may be that the level $V_{S1}$ of the signal line $S_1$ cannot be higher than the required level ($V_{CC}+V_{th}$). In such a case, the short-circuit between the pair of bit lines BL and $\overline{BL}$ through the transistor $Q_5$ is insufficient so that the sense amplifier circuit SA may make an error.

In addition to the voltage supply $V_{CC}$, the potentials of the electrodes X opposite the signal line $S_1$ forming the capacity $C_2$ might be throught of as another factor in relation to the response of the level $V_{S1}$ of the signal line $S_1$. In the semiconductor device of the prior art, the signal line $S_1$ is formed to run the shortest path between the push-up circuit PU and the precharger circuit PRE, and therefore the opposite electrodes along the path of the signal line $S_1$ may be locally the ground line $V_{SS}$, the semiconductor substrate itself, the other signal line, the node in the circuit, or the voltage supply line $V_{CC}$. However, the proportion of the path of the signal line $S_1$ opposite the voltage supply $V_{CC}$ is generally small, and the potential of the opposite electrode X as a whole could be thought of as being other than the voltage supply $V_{CC}$.

Therefore, depending on the pattern layout of the signal line $S_1$ the potential of the opposite electrode X is defined arbitrarily, and may be, normally, the ground level $V_{SS}$ or the substrate potential, or, in a rare case, the potential of the supply line $V_{CC}$.

Accordingly, in the semiconductor device of the prior art, improvement of the response of the level $V_{S1}$ to $V_{CC}$ according to the opposite electrode X cannot be expected.

Thus, as described above, when the voltage supply $V_{CC}$ increases by $\Delta V_{CC}$, the increase of the level $V_{S1}$ of the signal line $S_1$ is only $\Delta V_{S1}$ in the equation (2), and therefore it is difficult to push up the level $V_{S1}$ to a level higher than ($V_{CC}+V_{th}$) after $V_{CC}$ has increased, even if the clock $\phi_3$ increases by $\Delta V_{CC}$.

As mentioned previously, the device described above with reference to Figures 1 and 2 was not previously known to the public. However, a similar device is disclosed in US—A—3 646 369, and such a device suffers from the same problem as the Figures 1 and 2 device.

An object of the present invention is to alleviate the above-mentioned problem is the prior semiconductor devices, and to provide a semiconductor device is which the potential of the signal line can follow variations in the potential of the voltage supply line.

In accordance with the present invention there is provided a semiconductor device, comprising a signal generating circuit in which an output of the circuit can be cut off from a voltage supply line by a switching element and an output signal higher than the voltage supply is generated at the output; a signal line layer connected to the output; and a transistor having a gate which is connected to the signal line layer and a drain which is connected to the voltage supply line at least after the output is cut off from the voltage supply line; characterised in that the semiconductor device also comprises a conductive layer operatively connected to the voltage supply line through an insulating film, the conductive layer being laid over a predetermined area under the insulating film directly below the signal line layer so as to be capacitively connected therewith, which causes the potential of the signal line layer to follow variations in potential of the voltage supply line after the signal line layer is cut off from the voltage supply line.

Embodiments of the invention will now be described, by way of example, with reference to the accompanying drawings, in which:

Figure 1 is a circuit diagram of a previously-known semiconductor dynamic RAM as described above;

Figure 2 illustrates signal waveforms for explaining the operation of the circuit of Figure 1;

Figures 3A and 3B illustrate, respectively, a sectional view and a plan pattern view of one form of semiconductor device in accordance with the present invention;

Figure 4 illustrates an equivalent circuit of the semiconductor device of Figures 3A and 3B; and

Figures 5A and 5B illustrate, respectively, a sectional view and a plan pattern view of another form of semiconductor device in accordance with the present invention.

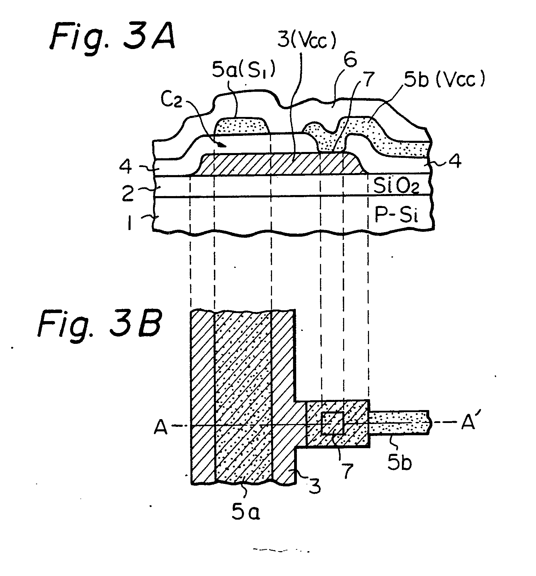

One form of semiconductor device in accordance with the present invention is illustrated in Figures 3A and 3B. Fig. 3A illustrates a principal sectional view of the above-mentioned semiconductor device and Fig. 3B illustrates a plan pattern view of the device.

The semiconductor device of Figs. 3A and 3B comprises a p-type silicon semiconductor substrate 1, a silicon dioxide ($SiO_2$) layer 2 on the surface of the substrate 1, a polycrystal silicon layer 3 formed on the $SiO_2$ layer 2, a phosphosilicate glass (PSG) layer 4 for insulating between layers formed on the polycrystal silicon layer 3, aluminum (Al) wiring layers 5a and 5b upon the PSG layer 4, and a PSG layer 6 for covering the surface of the device.

The Al wiring layer 5b is a voltage supply ($V_{CC}$) line and is connected through the contact hole 7 to the polycrystal silicon layer 3 which is also used as a voltage supply line. The other Al wiring layer 5a is a signal line $S_1$.

As illustrated in Fig. 3A, the polycrystal silicon layer 3 is arranged to be laid under the Al wiring layer 5a through the insulating PSG layer 4 as much as possible. Though as a way to arrange the polycrystal silicon layer 3 as described above, it may be thought to crook the path of the Al wiring layer 5a, in accordance with the embodiment of Fig. 3A it is preferable that the Al wiring layer 5a remains as it is and the polycrystal silicon layer 3 is formed under the Al wiring layer 5a through the insulating PSG layer 4 even though the layer 3 is not necessary there.

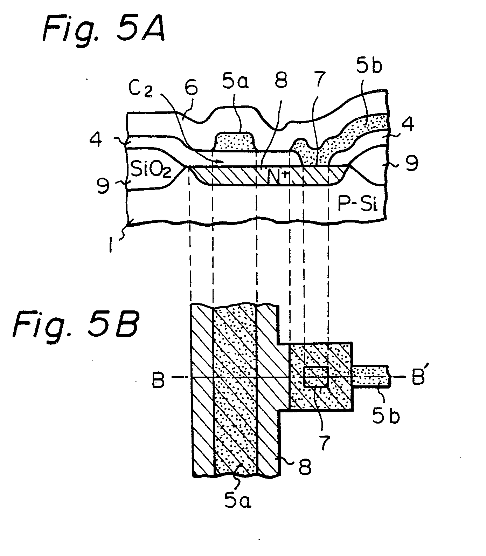

Fig. 4 illustrates an equivalent circuit diagram of the signal line $S_1$ of the semiconductor device of Fig. 3A. According to the semiconductor device of Fig. 3A, the potentials of the electrodes opposite the signal line $S_1$ are mainly the voltage supply $V_{CC}$, and the portion of the signal line $S_1$ opposite the potentials other than the voltage supply $V_{CC}$ is considered to be negligibly small. Accordingly, the opposite potential of the capacity $C_2$ which is formed along the path of the signal line $S_1$ is thought to be the voltage supply $V_{CC}$ as simplified.

In the circuit of Fig. 4, when the clocks $\phi_1$, $\phi_2$ and $\phi_3$ are changed as illustrated in Fig. 2, the level $V_{S1}$ of the signal line $S_1$ is expressed by the above-mentioned equation (1). If, after the clock $\phi_1$ falls to the L level to cut off the signal line $S_1$ from the voltage supply line $V_{CC}$, the voltage supply $V_{CC}$ rises by $\Delta V_{CC}$, the level $V_{S1}$ of the signal line $S_1$ is pushed up not only by the clock $\phi_3$ through the capacity $C_1$ but also by the voltage supply itself through the capacity $C_2$. Therefore, the level $V_{S1}$ of the signal line $S_1$ increase by $\Delta V_{S1}$ as expressed by the following equation:

$$\Delta V_{S1} = \Delta V_{\phi3} \cdot \frac{C_1}{C_1 + C_2 + C_3} + \Delta V_{CC} \cdot \frac{C_2}{C_1 + C_2 + C_3}$$

$$(3)$$

As described above, in the semiconductor device of Fig. 3A, the level of the signal line $S_1$ can follow the variance of the voltage supply $C_{CC}$ even after the signal line $S_1$ is cut off from the voltage supply line $V_{CC}$.

In addition, a semiconductor in accordance with another embodiment of the present invention is illustrated in Figs. 5A and 5B. Fig. 5A illustrates a principal sectional view of the above-mentioned semiconductor device and Fig. 5B illustrates a plan pattern view of the device. In the semiconductor device of Fig. 5A, a $N^+$-type diffusion layer 8 is formed upon a portion of the surface of the p-type silicon substrate 1, and a PSG layer 4 for insulating between layers is formed upon the field oxide ($SiO_2$) film 9 on the substrate 1 and upon the $N^+$-type diffusion layer 8. Al wiring layers 5a and 5b for the signal line $S_1$ and for the voltage supply line $V_{CC}$, respectively, are formed on the insulating PSG layer 4. A covering PSG layer 6 is formed on the surface of the device. The Al wiring layer 5b is connected to the $N^+$-type diffusion layer 8 through the contact hole 7. Therefore, a voltage supply wiring layer formed from the $N^+$-type diffusion layer 8 is laid directly under the Al wiring layer 5a of the signal line $S_1$ through the insulating PSG layer 4.

Furthermore, though the conductive layer laid under the signal line $S_1$ is formed as a voltage supply wiring line in the above-mentioned two embodiments, the above-mentioned conductive layer may be formed as a signal line other than the voltage supply line which follows the variance of the voltage supply $V_{CC}$. However, it is not preferable, from the view of the drive capacity of the clock $\phi_3$, to form the above-mentioned conductive layer as the output signal line of the clock $\phi_3$.

As described above, according to the present invention, by means of extending the voltage supply line or another signal line equivalent to the voltage supply as much as possible under the output signal line of a push-up circuit or another circuit, the above-mentioned output signal line can be shielded equivalently, the level of the output signal line can follow variations in the voltage supply by the capacity formed along the output signal line, and the level of the output line can be made so as to be difficult to be influenced by the variance of the substrate potential.

**Claims**

1. A semiconductor device, comprising a signal generating circuit (PU) in which is output ($S_1$) of the circuit can be cut off from a voltage supply line ($V_{CC}$) by a switching element ($Q_1$) and an output signal ($V_{S1}$) higher than the voltage supply is generated at the output; a signal line layer (5a) connected to the output; and a transistor $(Q_3, Q_4)$ having a gate which is connected to the signal line layer and a drain which is connected to the voltage supply line at least after the output is cut off from the voltage supply line; characterised in that the semiconductor device also comprises a conductive layer (3, 8) operatively connected to the voltage supply line $(V_{CC})$ through an insulating film (4), the conductive layer (3, 8) being laid over a predetermined area under the insulating film (4) directly below the signal line layer (5a) so as to be capacitively connected therewith, which causes the potential of the signal line layer (5a) to follow variations in potential of the voltage supply line $(V_{CC})$ after the signal line layer is cut off from the voltage supply line.

2. A semiconductor device as claimed in claim 1, characterised in that the conductive layer (3, 8) comprises a voltage supply line layer.

3. A semiconductor device as claimed in claim 1 or claim 2, characterised in that the conductive layer (3) is formed as a polycrystalline silicon layer.

4. A semiconductor device as claimed in claim 1 or claim 2, characterised in that the conductive layer (8) is formed as an $N^+$-type or $p^+$-type diffusion layer.

## Patentansprüche

1. Halbleitervorrichtung, mit einer Signalgeneratorschaltung (PU), in welcher ein Ausgang $(S_1)$ der Schaltung von einer Spannungsversorgungsleitung $(V_{CC})$ durch ein Schaltelement $(Q_1)$ abgeschnitten werden kann und ein Ausgangssignal $(V_{S1})$, das höher als die Spannungsversorgung ist, an dem Ausgang erzeugt wird; einer Signalleitungsschicht (5a), die mit dem Ausgang verbunden ist; und einem Transistor $(Q_3, Q_4)$, der ein Gate hat, das mit der Signalleitungsschicht verbunden ist, und ein Drain, das mit der Spannungsversorgungsleitung verbunden ist, zumindest nachdem der Ausgang von der Spannungsversorgungsleitung abgeschnitten ist; dadurch gekennzeichnet, daß die Halbleitervorrichtung auch eine leitende Schicht (3, 8) umfaßt, die wirkungsmäßig mit der Spannungsversorgungsleitung $(V_{CC})$ über einen isolierenden Film (4) verbunden ist, die leitende Schicht (3, 8) über einen vorbestimmten Bereich unter dem isolierenden Film (4) direkt unter der Signalleitungsschicht (5a) gelegt ist, um so kapazitiv mit dieser verbunden zu sein, was bewirkt, daß das Potential der Signalleitungsschicht (5a) Veränderungen des Potentials der Spannungsversorgungsleitung $(V_{CC})$ folgt, nachdem die Signalleitungsschicht von der Spannungsversorgungsleitung abgeschnitten worden ist.

2. Halbleitervorrichtung nach Anspruch 1, dadurch gekennzeichnet, daß die leitende Schicht (3, 8) eine Spannungsversorgungsleitungsschicht umfaßt.

3. Halbleitervorrichtung nach Anspruch 1 oder 2, dadurch gekennzeichnet, daß die leitende Schicht (3) als eine polykristalline Siliziumschicht gebildet ist.

4. Halbleitervorrichtung nach Anspruch 1 oder 2, dadurch gekennzeichnet, daß die leitende Schicht (8) als eine $N^+$-Typ- oder $p^+$-Typ-Diffusionsschicht ausgebildet ist.

## Revendications

1. Dispositif semiconducteur, comprenant un circuit générateur de signaux (PU) dans lequel une sortie $(S_1)$ du circuit peut être déconnectée d'une ligne d'alimentation en tension $(V_{CC})$ par un élément de commutation $(Q_1)$ et un signal de sortie $(V_{S1})$ plus élevé que l'alimentation en tension est produit au niveau de la sortie; une couche de ligne de signaux (5a) connectée à la sortie; et un transistor $(Q_3, Q_4)$ dont la grille est connectée à la couche de ligne de signaux et le drain est connecté à la ligne d'alimentation en tension au moins après que la sortie a été déconnectée de la ligne d'alimentation en tension; caractérisé en ce que le dispositif semiconducteur comprend également une couche conductrice (3, 8) fonctionnellement connectée à la ligne d'alimentation en tension $(V_{CC})$ via une pellicule isolante (4), la couche conductrice (3, 8) s'étendant sur une aire prédéterminée sous la pellicule isolante (4) directement au-dessous de la couche de ligne de signaux (5a) de façon à être connectée par capacité avec cell-ci, ce qui fait que le potentiel de la couche de la ligne de signaux (5a) suit les variations de potentiel de la ligne d'alimentation en tension $(V_{CC})$ après que la couche de ligne de signaux a été déconnectée de la ligne d'alimentation en tension. ,

2. Dispositif semiconducteur selon la revendication 1, caractérisé en ce que la couche conductrice (3, 8) comprend une couche de ligne d'alimentation en tension.

3. Dispositif semiconducteur selon la revendication 1 ou 2, caractérisé en ce que la couche conductrice (3) est faite sous forme d'une couche de silicium polycristallin.

4. Dispositif semiconducteur selon la revendication 1 ou 2, caractérisé en ce que la couche conductrice (8) est faite sous forme d'une couche de diffusion de type $N^+$ ou de type $P^+$.

# Fig. 1

# Fig. 2

# Fig. 4

0 055 038

Fig. 3A

$C_2$  
$5a(S_1)$  
$3(Vcc)$  
6  
7  
$5b(Vcc)$  
4  
2  
1  
$SiO_2$  
P-Si

Fig. 3B

A —— A'  
7  
$5b$  
3  
$5a$

3

## Fig. 5A

$C_2$  6  5a  8  7  5b

4  4

SiO₂  N⁺  9

9  9

P-Si

1

## Fig. 5B

B —  — B'

5b

7

8

5a

4